# EUROPEAN PATENT APPLICATION

(11) **EP 0 774 772 A1**
(43) Date of publication of application: **21.05.1997**
(21) Application number: 96308118.7
(22) Date of filing: 08.11.1996
(51) Int. Cl.: H01J 37/32, H01L 21/3065, C23F 4/00

(54) **Methods for physically etching silicon electrically conducting surfaces**

(30) Priority: 17.11.1995 US 560083
(71) Applicant: APPLIED MATERIALS, INC., Santa Clara, California 95054-3299 (US)
(72) Inventor: Ngan, King-Tai Kenny, Fremont, CA 94539 (US)
(74) Representative: Bayliss, Geoffrey Cyril

(57) **Abstract**

A method for physically etching electrically conducting surfaces using a plasma in a chamber (10) is disclosed. A ratio of plasma power supplied by an RF generator (16) through coil (18) supplied by generator (22) through cathode (24) to bias power supplied by generator (22) to bias power is selected that sustains low pressure etching with high etch uniformity. Etching is accomplished at reduced pressure with ionized species in the plasma attracted, as a result of the bias, to the surface (26) to be etched while maintaining substantially the same ratio of plasma power to bias power as in plasma striking step.

## Description

The present invention relates to methods for etching silicon or metallic surfaces. More particularly, the present invention relates to a physical etching method to clean semiconducting or metal wafers.

Commonly, it is desired to remove native oxide, dust or other contaminants from the surface of a silicon or aluminum wafer as a first step in semiconductor device fabrication. Conventional precleaning methods include sputter etching techniques by which the surface is physically bombarded by particles in a plasma. The surface typically is biased to attract ionized particles that often constitute a relatively small portion of the plasma. Cleaning is then accomplished as the ionized particles strike the surface, displacing small portions of the exposed surface of the wafer and contaminants thereon. There is no chemical reaction.

For such a plasma etching process, a plasma is ignited in an etching chamber during a high pressure strike step at, for example, 5 mTorr (mT) using an inductive power source supplying 300 W at 400 kHz. Typically, a d.c. bias is applied to the wafer delivering between about 125 W to 300 W of power at 13.6 MHz. Etching is carried out at relatively low pressures, typically less than 1 mT, since low pressure is recognized as important to achieving etch uniformity across the wafer. However, under the low pressure conditions of the etch step, maintenance of an adequate plasma with which to etch is very difficult because the proportion of the ionized species in the plasma consumed at the cathode is exceedingly high.

During the etch step, displaced etch byproducts may redeposit on the inner chamber adjacent to the plasma power source. Dielectrics, such as silicon oxide, do not interfere with coupling of the power to the plasma via the chamber walls. However, deposition of materials containing conducting or semiconducting elements such as silicon or aluminum can interrupt coupling between the power source and the plasma to the point that plasma is not sustained consistently during etch.

Consequently, there is a need for an etching process that sustains plasma adequately even when etching conducting or semiconducting surfaces while maintaining etch uniformity.

The present invention provides a method for etching conducting or semiconducting materials using a physical etching mechanism.

According to one aspect of the present invention, argon gas is flowed into an etching chamber. Power is provided to generate a plasma that includes ionized argon and to bias the surface to be treated. Etching is carried out at a reduced pressure. However, plasma power is sufficient to maintain the plasma during the etch step while achieving an adequately high etch rate.

In another aspect of the present invention, a surface is physically etched using a plasma. A plasma is struck at high gas pressure within a processing chamber with an inductively coupled power source while the surface to be treated is biased by applying a d.c. potential. The surface is then etched at a reduced gas pressure with ionized species attracted as a result of the bias while maintaining the same ratio of plasma power to bias power as in the strike step.

A preferred ratio of plasma power to bias power is about 10:1.

A method according to the present invention may be utilized as a precleaning step for semiconductor device fabrication.

The various features of the present invention may be more fully understood with reference to the following description and the accompanying figures in which:
Figure 1 illustrates a typical contour map for oxide etch achieved using a method according to the present invention;
Figure 2 illustrates a typical d.c. bias plot during an etch precleaning of a silicon wafer using a mechod according to the present invention; and
Figure 3 illustrates an apparatus capable of carrying out a method according to the present invention.

Generally, the present invention relates to a method for achieving physical etching of a conducting or semiconducting surface using a plasma. A method according to the present invention maintains a sufficiently high ratio of plasma power to bias power to maintain an adequate plasma and supply of etching species in view of consumption of etching species at the cathode. Consequently, plasma etching is sustained even where deposits of electrically conducting or semiconducting etch byproducts within a processing chamber would otherwise interfere with coupling of plasma power to the plasma.

A method according to the present invention may be carried out in two general steps: high pressure plasma ignition and bias of the surface to be treated; and low pressure etching. Each of these steps is discussed in turn.

The plasma is ignited once steady state conditions are achieved in a processing chamber. Thus, a gas capable of sustaining a plasma for physical etching, such as argon, is flowed into the chamber until gas flow is stabilized. Power for ignition may be supplied using an inductively coupled source such as an RF coil.

A surface to be etched, e.g., a silicon or aluminum wafer, is supported in the chamber on a cathode or pedestal that is biased to attract charged species, such as ionized argon, from the plasma by which etching is achieved. Bias power is typically applied to the surface by applying a d.c. potential to the wafer through the cathode or pedestal. The magnitude of the bias on the surface should be sufficient to attract charged etching species without deteriorating the plasma to a point where the plasma cannot be sustained consistently. Bias power may be applied either during gas introduction into the chamber before plasma strike or simultaneously with the application of plasma power.

Qualitatively, a suitable plasma power to bias power ratio is one at which the plasma remains stable during the etching step and an adequate etch rate, in terms of uniformity and process throughput, is achieved. Thus, where plasma power at 400 kHz is about 400 W, suitable bias power at 13.6 MHz is generally less than about 100 W. A preferred range for plasma power to bias power is between 4:1 and 12:1.

During the etching step, ionized argon from the plasma bombards the exposed surface and removes, through momentum transfer, small portions therefrom. Thus, no chemical reaction takes place between the etching species and the etched surface. For the etching step, pressure may be relatively reduced in order to enhance etch uniformity, but the ratio of plasma power to bias power is maintained substantially the same as in the strike step.

Smooth transition from the strike step through to the etch step can be achieved by maintaining a constant ratio of plasma power to bias power therebetween, even as the pressure is reduced in order to achieve etch uniformity across the wafer.

The strike step is completed using a relatively high gas pressure, typically at least about 5 mT, and the etch step is typically conducted at less than about 1 mT. Gas introduction into the chamber for the strike step is desirably maintained for a sufficient length of time to ensure flow stabilization within the chamber prior to plasma strike. Gas flow may be reduced just prior to the etch step to assist in reducing the pressure for the etch step.

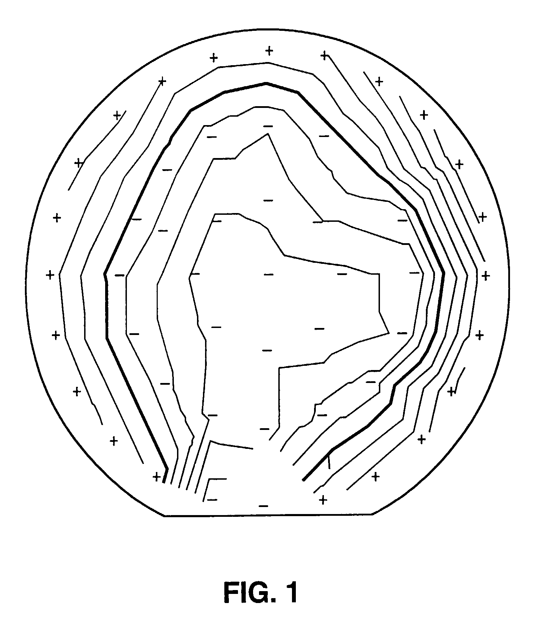

Figure 1 illustrates a typical contour map of the surface of a silicon wafer after etching using a method according to the present invention. The contour interval was 1 Å. Etch uniformity was measured to be 1.9% (1 sigma, standard deviation) and ±3.5% (max/min). Etch rate was about 158 Å per minute.

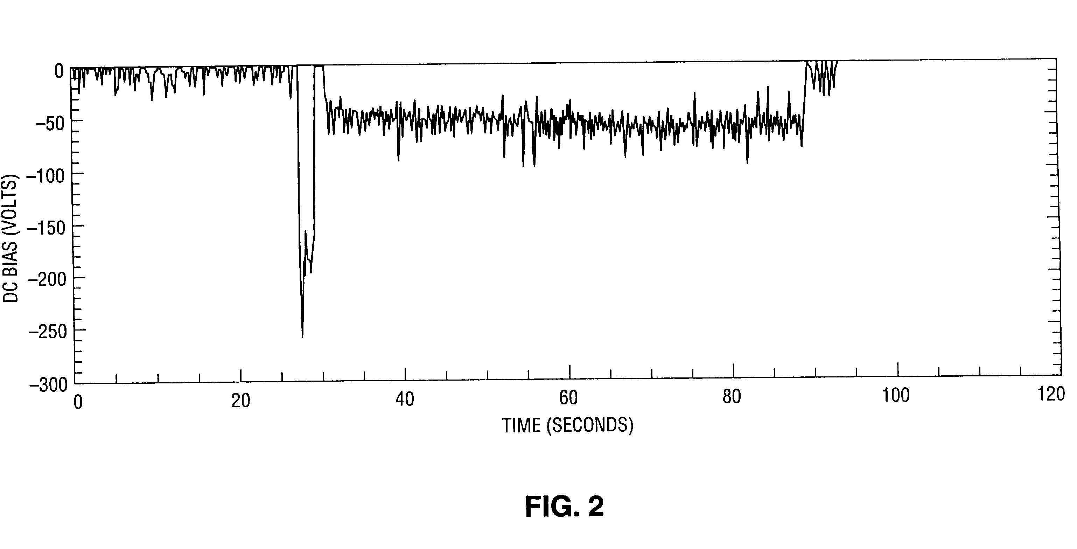

Figure 2 illustrates a typical bias plot for etching a silicon wafer using a method according to the present invention. Process conditions were: bias power of 40 W (13.6 MHz) and plasma power of 390 W (400 kHz) (plasma power to bias power ratio was ∼9.8:1), 5 mT argon strike and 0.5 mT argon etch. The substantial constancy of the d.c. bias at about -50 V during the etch step (beginning at about t = 30 seconds) reflects the stability of the etch step even at low pressure. An unstable plasma is manifested as a d.c. bias that fluctuates or gradually approaches zero.

Methods according to the present invention may be carried out using conventional plasma processing equipment. Suitable plasma precleaning chambers include those used in the ENDURA™ and CENTURA™ plasma processing systems commercially available from Applied Materials, Incorporated of Santa Clara, California.

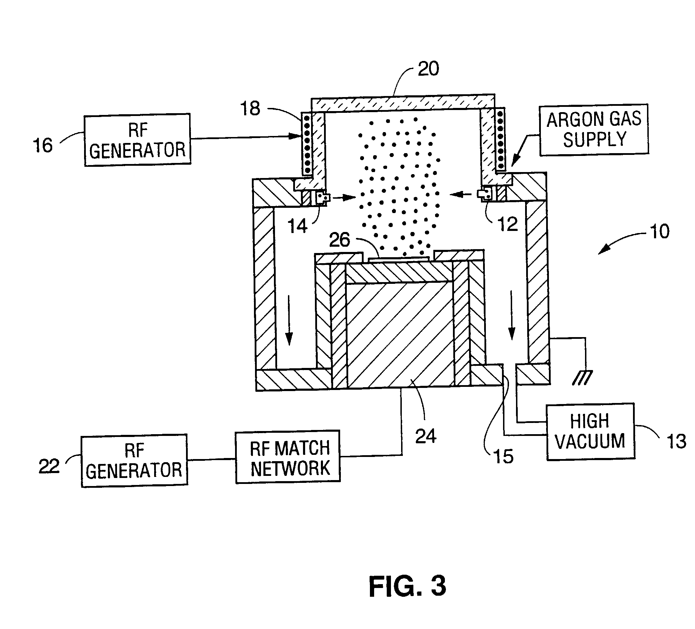

In Figure 3, an exemplary etch preclean chamber capable of carrying out a method according to the present invention is illustrated. The etching process takes place in a chamber 10 into which gas inlets 12 and 14 introduce argon. Plasma power is supplied by an RF generator 16 through a coil 18 wound about the upper portion 20 of the chamber. The chamber is evacuated, as needed, via an outlet 15 through connection to a pump 13. Bias power is supplied by an RF generator 22 electrically connected to cathode 24 that supports wafer 26 in the chamber.

For the preclean chambers associated with the ENDURA™ and CENTURA™ plasma processing systems having about 5-10 liter capacity, gas flow rates prior to strike are typically between about 0 sccm and 110 sccm, with about 100 sccm being preferred. This gas flow is substantially maintained until steady state is achieved. Gas flow may be reduced to about 5 sccm for etch. A high plasma power to bias power ratio is maintained at substantially the same value throughout the strike/bias (≈3 seconds) and etch (≈60 seconds) steps.

The embodiments and examples described above are intended to be illustrative of the present invention. They are not intended to be limiting. It is contemplated that modifications will readily occur to those skilled in the art and any such modifications that come within the scope of the following claims are covered by the present invention.

## Claims

1. A method for physically etching an electrically conducting surface in a processing chamber, comprising the steps of:
flowing argon gas into the chamber to establish steady state conditions;
biasing the surface in the chamber;
providing power to generate a plasma under the same steady state conditions, the plasma comprising ionized argon; and
uniformly etching the surface with the ionized argon at a reduced pressure,
wherein the plasma power is sufficient to maintain the plasma during the etching step.

2. A method according to claim 1, wherein the pressure during the etch step is reduced by reducing the argon gas flow rate into the chamber.

3. A method according to claim 1, wherein the ratio of plasma power to bias power is between about 4:1 to 12:1.

4. A method according to claim 1, wherein the ratio of plasma power to bias power is at least about 10:1.

5. A method for physically etching a metal or semiconducting surface using a plasma, comprising the steps of:
biasing the surface by applying a d.c. potential;
striking a plasma at a high gas pressure within a processing chamber with an inductively coupled power source;
etching the surface at a reduced gas pressure with ionized species attracted to the biased wafer while maintaining the same ratio of plasma power to bias power as in the striking step.

6. A method for semiconductor device fabrication, comprising the step of:
precleaning a surface of a semiconductor wafer in a processing chamber, comprising the steps of:
generating at high pressure a plasma comprising ionized argon while maintaining a high argon gas flow into the chamber simultaneously with biasing the wafer in the chamber;
bombarding the surface with ionized argon to clean the surface at a reduced pressure; and
simultaneously with the bombarding step, maintaining the same ratio of plasma power to bias power as in the plasma generating step.

7. A method according to claim 5, wherein the plasma power to bias power ratio is between about 4:1 and 12:1.

8. A method according to claim 7, wherein the ratio of plasma power to bias power is between about 10:1.

9. A method according to claim 6, wherein the bombarding step is carried cut at a pressure less than 1 mT.
